# EUROPEAN PATENT APPLICATION

(11) **EP 0 678 912 A2**
(43) Date of publication of application: **25.10.1995**
(21) Application number: 95105908.8
(22) Date of filing: 20.04.1995
(51) Int. Cl.: H01L 21/762, H01L 21/312, H01L 21/3105

(54) **Isolation of transistors using trenches filled with dielectrics having low dielectric constant K**

(30) Priority: 20.04.1994 US 230356
(71) Applicant: TEXAS INSTRUMENTS INCORPORATED, Dallas Texas 75265 (US)
(72) Inventor: Tigelaar, Howard L., Allen, TX 75002 (US)
(74) Representative: Schwepfinger, Karl-Heinz, Dipl.-Ing.

(57) **Abstract**

A method of transistor isolation is described. The method comprising: depositing a masking layer 52 above a semiconductor material layer 50; patterning the masking layer 52 in a trench configuration; etching trenches within the semiconductor material layer 50; removing the masking layer 52; oxidizing the semiconductor material layer; depositing a low dielectric material layer 58 having a dielectric constant of less than 3.3 above the semiconductor material layer 50; and removing portions of the low dielectric material layer not within the trenches. The invention also includes a semiconductor device with a plurality of transistors 10, 22 comprising at least one trench with a low dielectric material 58 in between at least some of the plurality of transistors.

## Description

### FIELD OF THE INVENTION

This invention relates to semiconductor device manufacturing. In particular, the invention relates to isolation of transistors.

### BACKGROUND OF THE INVENTION

Semiconductors are widely used in integrated circuits for electronic applications, including radios and televisions. Such integrated circuits typically use multiple transistors fabricated in single crystal silicon. Many integrated circuits now contain multiple levels of metallization for interconnections. A single semiconductor microchip may have thousands, and even millions of transistors.

These transistors must be electrically isolated from each other or unwanted electrical malfunctions can occur. In MOS (metal oxide semiconductor) technology, the isolation typically consists of thermal oxide which is grown to a thickness which is sufficient to keep the parasitic transistor, which is formed when a polysilicon line crosses over the isolation oxide, from activating. If this isolation oxide is too thin, voltage on the poly line can capacitively couple to the silicon below causing a parasitic transistor to turn on.

Various techniques are known to those skilled in the art for ensuring that such parasitic transistors do not activate under normal operating conditions. For example, the farther apart regular transistors are from each other, the less likely that a parasitic transistor will activate. Additionally, the thicker the isolation oxide is between the regular transistors, the less likely that a parasitic transistor will activate. However, it is desirable in the manufacture of semiconductor devices to compact more regular transistors into a smaller area. Consequently, the isolation problem becomes more acute as semiconductor device density increases. One method of transistor isolation is to create trenches between the transistors.

### SUMMARY OF THE INVENTION

It has been found that such conventional trenches have shortcomings. For example, some of the trenches used in the art are deep and difficult to manufacture.
Other trenches are too wide and would reduce the amount of transistors horizontally.

Therefore, minimizing the size of the trench used to isolate the transistors is very important. This invention details a semiconductor device with transistor isolation trenches that are minimal in size. The present invention also details how to create such a semiconductor device.

The present invention utilizes materials with low dielectric constant (low-k) to fill such trenches. The dielectric constant is based on a scale where 1.0 represents the dielectric constant of a vacuum. Various materials exhibit dielectric constants from very near 1.0 to values in the hundreds. For example, silicon dioxide has a dielectric constant of about 3.9. As used herein, the term low-k will refer to a material with a dielectric constant less than 3.3.

The low-k dielectric material allows the trenches to be minimal in depth and width in relation to other materials used in trenches because it reduces the capacitance coupling between the devices. The method of producing such trenches can comprise: depositing a masking layer above a semiconductor material layer; patterning the masking layer in a trench configuration; etching trenches within the semiconductor material layer; removing the masking layer; oxidizing the semiconductor material layer; depositing a low dielectric material layer having a dielectric constant of less than 3.3 above the semiconductor material layer; and removing portions of the low dielectric material layer not within the trenches.

The invention also includes a semiconductor device with a plurality of transistors comprising at least one trench with a low dielectric material in between at least some of the plurality of transistors.

Preferably, the masking layer is photoresist, and the removing of the low dielectric material is performed by a chemical mechanical polishing process or by resist etchback.

In addition, the low dielectric material layer may be polyimide or organic containing dielectric material such as polymeric spin-on glass.

### BRIEF DESCRIPTION OF THE DRAWINGS

This invention can be best understood by reference to the following drawing(s), in which:
Figure 1 is a cross section of two transistors on a semiconductor substrate;
Figures 2-6 depict an expanded view of the cross-section of figure 1 under different steps of the preferred embodiment; and
Figure 7 is a cross section of the preferred embodiment.

### DESCRIPTION OF THE PREFERRED EMBODIMENTS

In one embodiment. this invention provides a method of creating a trench of minimal size for isolation of transistors. The following drawings demonstrate only one method of practicing the invention, and are not meant to limit the invention to only the described embodiment.

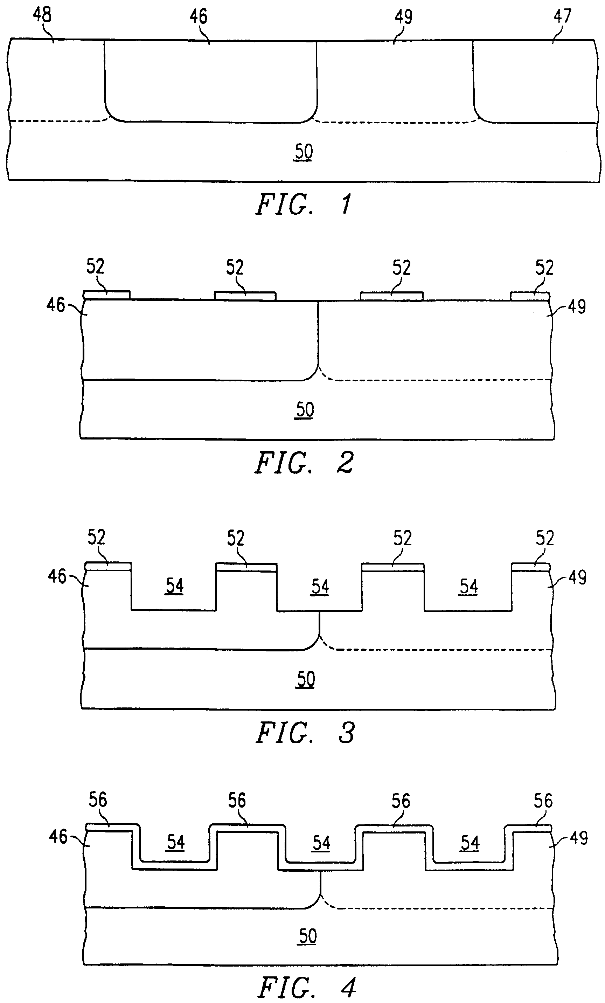

Figure 1 depicts a typical CMOS process, with the nwell 46, 47 and pwell 48, 49 regions formed in a silicon substrate 50 utilizing conventional methods. A thin oxide (e.g. approximately 25 - 50 nm) is then formed on the substrate (the thin oxide is not shown).

In order to focus on the fabrication process of the isolation trenches, Figures 2-6 are enlarged views of the nwell 46 and pwell 49 regions. A photoresist is then deposited and patterned to create the trenches. Figure 2 depicts a patterned photoresist 52 above the substrate 50 in relation to the regions 46 and 49. A typical process to create the trench is shown in the figure (specific examples of isolation trenches are: "TRENCH ISOLATION PROCESS WITH REDUCED TOPOGRAPHY", by Mark S. Rodder, U.S. Patent Number 5,223,736; "SEMICONDUCTOR INTEGRATED DEVICE", by Kamigaki et al., U.S. Patent Number 5,083,193; and "TRENCH ISOLATION STRUCTURE HAVING A TRENCH FORMED IN A LOCOS STRUCTURE AND A CHANNEL STOP REGION ON THE SIDEWALLS OF THE TRENCH", by Sudhir K. Madan, patent application number 07/949,656).

The trenches are then be etched using conventional procedures. Figure 3 depicts the photoresist 52, and the etched trenches 54 within the substrate 50. Next, the photoresist is be stripped from the substrate.

A thin oxide (e.g. 100 to 500 A) is then be grown on top of the substrate, as well as along the sides and bottom of the trenches. Figure 4 depicts the trenches 54, and the oxide 56, as well as the substrate 50.

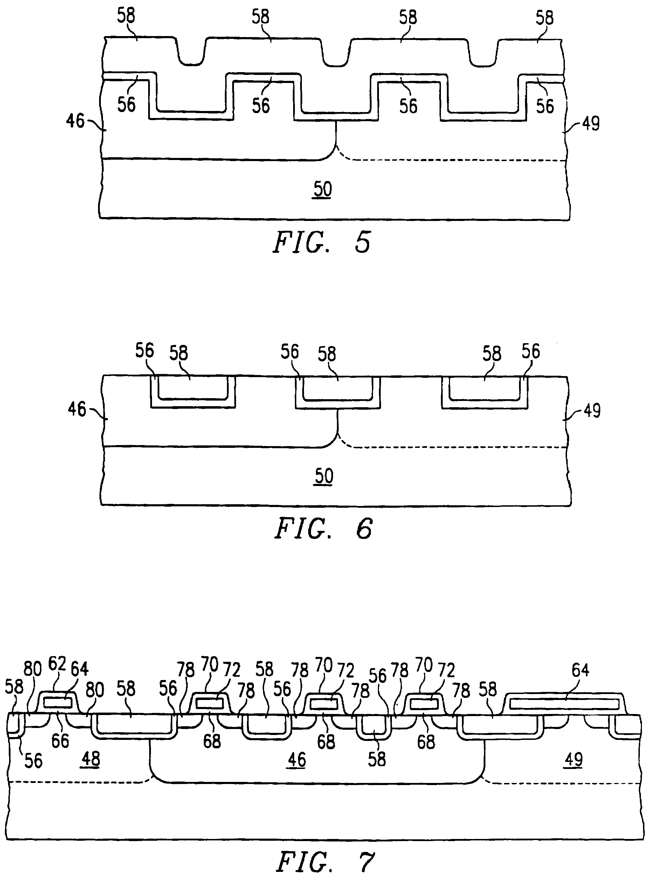

Low-k dielectric material is then be deposited in the trenches. The material could be also be spun-on. Figure 5 shows a layer of low-k dielectric material 58 within the trenches, as well as above the rest of the substrate 50.

The low-k dielectric is then be taken off the substrate in all areas except the trenches. This could be done by any planarization technique (e.g. CMP - Chemical Mechanical Polishing Process or REB - resist etchback). The removal of the low-k dielectric material could also be etched by conventional methods. The resulting trenches 58 are depicted in figure 6 and have a planar surface. Note, the resulting trenches are also shallow in size. The shallow trenches are possible because the low-k dielectric material does not require as much depth as higher-k dielectric materials.

The rest of the n-channel and p-channel transistors are now formed on the substrate in the areas outside the isolation trenches utilizing conventional methods. Figure 7 shows the trenches in relation to the CMOS transistors. The gates, 64, 72; oxide 62, 70 on top of the gates 64, 72; sidewalls 60, 68 on the side of gates 64, 72; gate oxides 66, 74 beneath gates 64, 72; N+ source and drain regions 80; and P+ source and drain regions 78; all on top of the substrate 50. The area between the transistors, as depicted in an expanded view in figures 2-6, is now reduced to show the relationship of the isolation trenches to the CMOS transistors. Logically, the number of trenches between the transistors could be varied and still provide the isolation that the transistors require.

The invention is not to be construed as limited to the particular examples described herein, as these are to be regarded as illustrative, rather than restrictive. The invention is intended to cover all (processes, articles, etc.) which do not depart from the spirit and scope of the invention. For example, the trenches do not have to within a substrate. The trenches may be put wherever transistor isolation is needed. In addition, the low-k dielectric trenches could also serve to isolate other electrical devices. Any low-k dielectric material can be used in the invention that is stable up to temperatures required for transistor fabrication (e.g. organic containing dielectric material such as polymeric spin-on glass).

## Claims

1. A method of isolating transistors comprising:
a. depositing a masking layer above a semiconductor material layer;
b. patterning said masking layer in a trench configuration;
c. etching trenches within said semiconductor material layer;
d. removing said masking layer;
e. oxidizing said semiconductor material layer; and
f. depositing a low dielectric material layer having a dielectric constant of less than 3.3 above said semiconductor material layer.

2. The method of claim 1 and including the stop of removing portions of said low dielectric material layer not within said trenches.

3. The method of Claim 2, wherein said removing portions of said low dielectric material layer consists of chemical mechanical polishing.

4. The method of Claim 2, wherein said removing portions of said low dielectric material layer consists of resist etchback.

5. The method of claim 1 and including the step of planarizing said low dielectric layer.

6. The method of Claim 5, wherein said planarizing consists of chemical mechanical polishing process.

7. The method of Claim 5, wherein said planarizing consists of resist etchback.

8. The method of any preceding claim, wherein said masking layer consists of photoresist.

9. The method of any preceding claim, wherein said low dielectric material consists of organic containing spin-on glass.

10. The method of any ofclaims 1-8 and, wherein said low dielectric material consists of polyimide.

11. A semiconductor device formed by the method of any preceding claim.

12. A semiconductor device with a plurality of transistors, comprising:
a. at least one trench between at least a portion of said plurality of transistors; and
b. a low dielectric material, with a dielectric constant of less than 3.3, within said at least one trench.

13. The device of Claim 12, wherein said low dielectric material consists of organic containing spin-on glass.

14. The device of Claim 12, wherein said low dielectric material consists of polyimide.
